# EUROPEAN PATENT APPLICATION

(11) **EP 1 111 978 A1**
(43) Date of publication of application: **27.06.2001**
(21) Application number: 99830804.3
(22) Date of filing: 24.12.1999
(51) Int. Cl.: H05K 7/14

(54) **Bent section rails of subrack for electronic components and subrack comprising said bent section rails**

(71) Applicant: Marconi Communications Network Components & Services - Italia S.p.A., 05100 Terni (IT)
(72) Inventor: Barbarossa, Gino, Marconi Com. Net. Comp. & Serv., 05100 Terni (IT); Fioretti, Fabio, Marconi Com. Net. Comp. & Serv., 05100 Terni (IT); Pistilli, Mauro, Marconi Com. Net. Comp. & Serv., 05100 Terni (IT)
(74) Representative: Leone, Mario

(57) **Abstract**

A bent section rail (1) of subracks (20) for electronic components has a sturdy and modular structure of simple construction and it comprises: a bent plate of an elongated parallelepiped shape, with a inner channel (7), a front wall (2) connected to a base wall (4) ; a fastening guide (8), obtained at the rear of the front wall (2) and delimited by bent portions (2, 4, 5, 9, 14) of said plate; a plurality of first fastening openings (10), obtained in said front wall (2); and a fastening strip (11), apt to be inserted in the fastening guide (8), having a plurality of second fastening openings (12) embodying respective fastening seats (10, 12) with said first openings (10).

## Description

The present invention relates to a bent section rail of subrack for electronic components and to a subrack for electronic components comprising said bent section rails.

The rail, considered for the scope of the present invention, is of the type incorporating fastening systems for the installation of electronic cards, located inside the subrack for electronic components that can advantageously be mounted in cabinets for electronic components or the like.

The rails commonly used in the field of electronics are usually made with extruded sections in which guides and grooves integral to said fastening systems are formed. Usually, inside a front guide of said extruded section, a fastening strip is inserted, having a plurality of threaded openings, spaced with a minimal pitch, apt to be engaged by conventional bolts and screws for mounting an electronic card in the desired position with respect to the rail extension, and therefore to the subrack.

Although providing satisfactory card mounting flexibility and subrack sturdiness, this system requires an high number of machining steps, in order to obtain the right extruded section profile; the required surface finishing of the components that is essential to ensure a conduction continuity in the mounted subrack; and all the constructive details that are required for mounting the rail in a subrack.

The fulfilment of all those requirements implies a higher complexity in the manufacturing processes of said rails, and, among other consequences, an increased cost thereof.

In order to partially overcome these drawbacks, rails obtained by a plate have been adopted, consisting of a sheet metal, bent so as to assume the boxed shape of an elongated parallelepiped. This technique, although simplifying the manufacturing process, required the addition of fastening systems for electronic cards as a further machining step, leading to fastening systems implying a specific and non flexible electronic card mounting standard.

Therefore, not allowing the manufacture of rails of a highly flexible use and satisfactory overall sturdiness, this manufacturing technique has not been widely adopted, remaining confined to niche products.

The technical problem underlying the present invention is that of providing a bent section rail of subracks for electronic components, allowing to overcome the drawbacks mentioned with reference to the known art.

Such problem is overcome by a bent section rail as disclosed above, characterised in that it comprises:
* a plate bent in an elongated parallelepipedal, boxed shape, defining a inner channel, so that the rail has a front wall connected to a base wall, developed lengthwise with respect to the rail;
* a fastening guide, formed in the inner channel along said front wall and defined by bent portions of said plate;
* a plurality of first fastening openings, formed in said front wall; and
* a fastening strip, apt to be inserted and locked inside said fastening guide, adjacently to the front wall, having a plurality of second fastening openings located in a position to correspond to the respective first fastening openings, in such a way to embody a fastening seat therewith.

The main advantage of the rail according to the present invention lies in that it allows a high flexibility for mounting cards on different positions, matched with structural sturdiness and modularity of the components constituting the subrack.

The subrack for electronic components comprising the rails according to the invention has a simple construction, providing a limited number of components.

The present invention will hereinafter be described according to two preferred embodiments thereof, given by way of example and not for limitative purposes with reference to the annexed drawings, wherein:
* figure 1 is a partially sectional perspective view of a first embodiment of a rail of subracks for electronic components according to the invention, preset for a front positioning thereof in a subrack for electronic components;
* figure 2 is a partially sectional perspective view of the rail of figure 1, preset for a rear positioning thereof;
* figure 3 is a cross section of the rail of figure 1 along the section line C-C;
* figure 4 is a cross section of the rail of figure 2 along the section line B-B;
* figure 5 is a partially sectional and exploded perspective view of a subrack for electronic components incorporating the rail of figure 1;
* figures 6a and 6b are partially sectional perspective views of a detail of a subrack incorporating a rail according to the present invention, according to two different embodiments thereof;
* figures 7a and 7b are detailed cross sections of a detail shown in Figs. 6a, 6b, along D-D and E-E section lines, respectively;
* figure 8 is a perspective view of the subrack of figure 5, mounted and operational;
* figure 9 is a perspective and partially sectional view of a second embodiment of a rail of subracks for electronic components according to the invention;
* figure 10 is a cross section of the rail of figure 5, along a section line A-A; and
* figure 11 is a partially sectional and exploded perspective view of a subrack for electronic components incorporating the rail of figure 9.

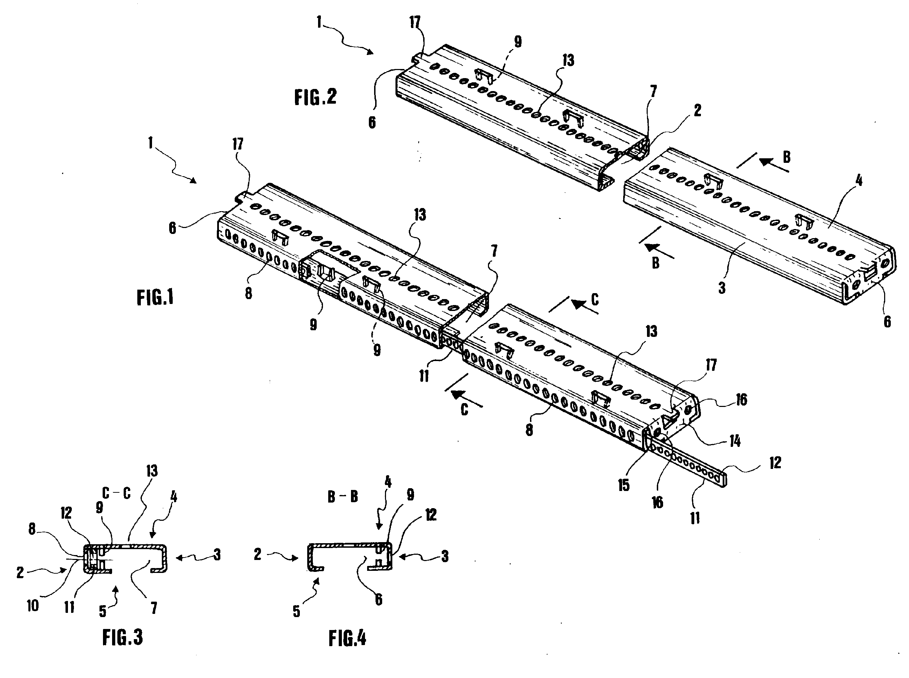

With reference to figures 1 to 4, a bent section rail of subracks for electronic components is indicated 1. It is of the type used in subracks for electronic components, i.e., those subracks destined to house electronic cards aligned inside the subrack, vertically juxtaposed and fastened to the subrack at the front access side, upperly and lowerly delimited just by said rails. The ends of a front strap of the card are fastened to the rails, e.g. with screws.

Therefore, said rails are of the type comprising fastening systems for electronic cards of the specified type.

The rail 1 has a flattened and elongated boxed parallelepipedal shape, developing along a main direction and identifying a front wall 2, a rear wall 3, corresponding to the longitudinal faces with a reduced thickness and developing lengthwise with respect to the rail 1; connected by a first and a second base wall 4, 5; end 6; and a inner channel ideally delimited by said walls 2, 3, 4, 5.

According to the present embodiment, said rail 1 comprises a bent plate that embodies and defines the walls 2, 3, 4, 5 of said rail 1.

Said plate is a galvanised steel sheet, preferably of a 1.5 mm thickness. It is mechanically cold bent to have a 0.6 mm bend radius.

In particular, the rail 1 has a C-shaped section and comprises said front wall 2 connected to the first base wall 4, in turn connected to the rear wall 3. The front wall 2 and the rear wall 3 have a 90° bending to define a front and a rear runway in the rail 1, further defining said second base wall 5 that is centrally opened.

At the front runway, the rail 1 comprises a fastening guide 8 that therefore is obtained in the inner channel 7. The fastening guide is adjacent to the front wall 2, the former being precisely delimited by the face thereof internal to the rail 1.

At the base wall 4, the rail 1 comprises a plurality of tongues 9 belonging to the plate and advantageously obtained by punching, so as to bend them internally to the inner channel 7 to delimit said fastening guide 8.

The rail 1 comprises a plurality of first fastening openings 10, in particular circular holes, formed e.g. by cold forging.

Said first openings 10 are sequentially located along said front wall 2, evenly spaced according to a minimal pitch.

Further, the rail 1 comprises an attachment, physically distinct therefrom but functionally connected thereto, consisting of a fastening strip 11, i.e. a stiff metal strip apt to be inserted inside said fastening guide 8 and to be locked therein, having transversal dimensions realising a minimal sliding clearance inside of the guide 8.

Thus, the fastening strip 11 is located adjacently to the front wall 2, in particular to the inner face thereof. It has a plurality of second fastening openings 12 that are located in a position to correspond to the respective first fastening openings 10, when the fastening strip 11 is locked inside the fastening guide 8. For this purpose, the second openings 12 are sequentially located along the fastening strip 11, evenly spaced according to the same minimal pitch of the first openings 10.

Thus, together the first fastening openings 10 and the respective second fastening openings 12 are apt to embody a fastening seat 10, 12.

Even the second fastening openings 12 are circular holes, in the present embodiment having a slightly shorter diameter than that of the first fastening openings 10. Further, the second openings have a counterthread onto the inner surface thereof, for fastening screw means inside of the fastening seat 10, 12.

At the first base wall 4 thereof, i.e. the upperly positioned one, the rail 1, has a plurality of third fastening openings 13, sequentially located on a row developing lengthwise with respect to the rail.

Alike the previous ones, also the third openings 13 are obtained by steel sheet cold forging prior to the bending and galvanising steps. They are evenly spaced with a minimal pitch, and conjugate with the respective third openings 13 of a complementary rail 1 (Fig. 3), realising an even spacing perpendicularly to the development of the rails 1.

The object of the third openings 13 and of the respective even spacing will be made apparent hereinafter.

The rail 1, at the ends 6 thereof, comprises a cap 14 belonging to the sheet metal, connected to the first base wall 4 and with a 90° bending, closing the inner channel 7.

The cap 14 is truncated at the insertion guide 8, and it constitutes, with the edges of the base walls 4, 5 and the edge of the front wall 2, a insertion slot 15 of the fastening strip 11.

Overall, the front wall 2, the base walls 4, 5, the tongues 9 and the caps 14 globally embody bent plate portions defining the fastening guide 8.

End holes 16, apt to house an assembling device, e.g. rivets, that will be disclosed hereinafter, are obtained in the caps 14. The rail 1 has a dowel 17 centrally notched in the respective cap 14, not bent therewith as it belongs to the first base wall 4.

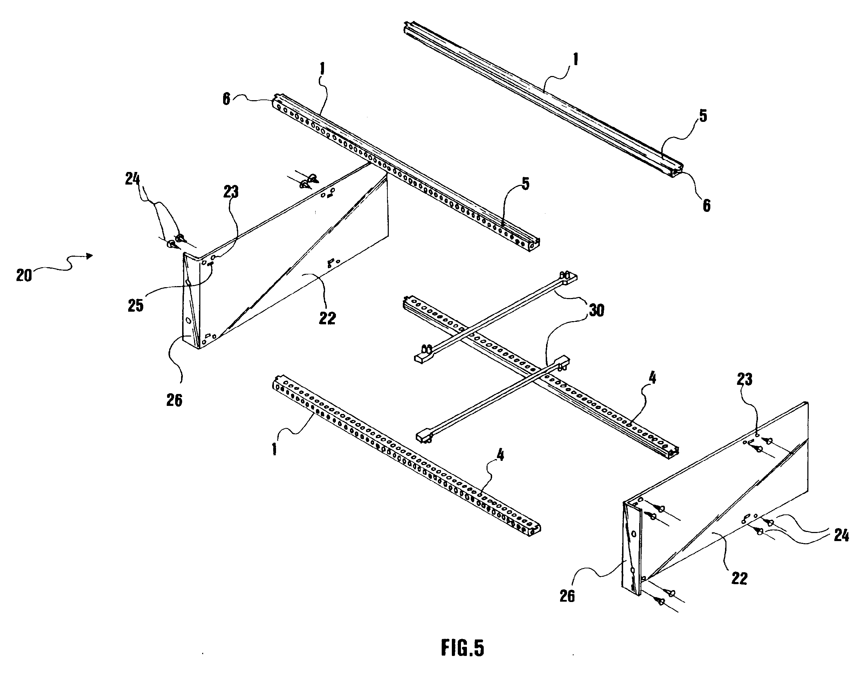

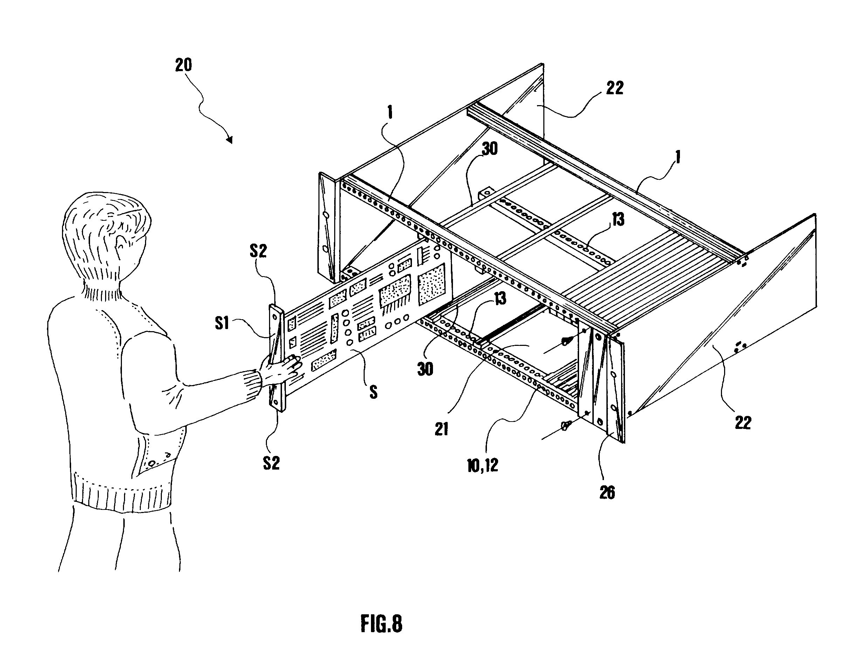

In Figures 1, 2, so as in figures 3 and 4, the mutual positioning of rails 1 apt to be assembled at an upper or lower face of a subrack 20, shown in an exploded view in Figure 5 and assembled in Figure 8.

In Figure 1 a first rail apt to be positioned at the access side 21 of the subrack 20 is shown, whereas a second rear rail is shown in figure 2. The first rail has said fastening strip 11 inserted inside the respective fastening guide 8, whereas the second rail is not provided with it. Anyhow, the first base walls 4 are upturned.

The assembling of the subrack 20 will hereinafter be illustrated with reference to Figure 5.

The subrack 20 is apt to have a flattened parallelepipedal shape, with a greater longitudinal development lengthwise the rails 4, a front access side 21 opened at a narrower longitudinal face, a card insertion depth from said front face to the respective rear face, and end faces.

It comprises four rails 1, a pair of front rails 1 with the respective fastening strips (not shown) inserted and another pair of rear rails 1, each rail 1 being located at the longitudinal corners of the subrack 20.

The rails 4 are mutually fastened by rectangular plates 22 located at the end faces of the subrack 20. The plates 22 comprise pairs of counterholes 23, located at the end holes 16 and apt to constitute with the latter a housing seat of an assembling device, i.e. the rivets 24. Furthermore, between each pair of counterholes 23 the plate 22 has a slot 25 apt to be engaged by said dowel 17.

At the frontally positioned edge of the plate 22, the plate itself has a further drilled fastening strip 26, for assembling the subrack 20 inside of a cabinet for electronic components.

In order to ease the assembling of the subrack 20, the plates 22 are symmetrical with respect to a median axis, concordant to the direction of insertion of the electronic cards.

Prior to fastening the plates 22 to the rails 1, it is necessary to position the respective fastening strips 11, which will be found correctly locked in place once the assembly of the plates 22 is carried out, taking into account that the rails 1 and the fastening strips 11 are of equal length, thus embodying the fastening seats 10, 12.

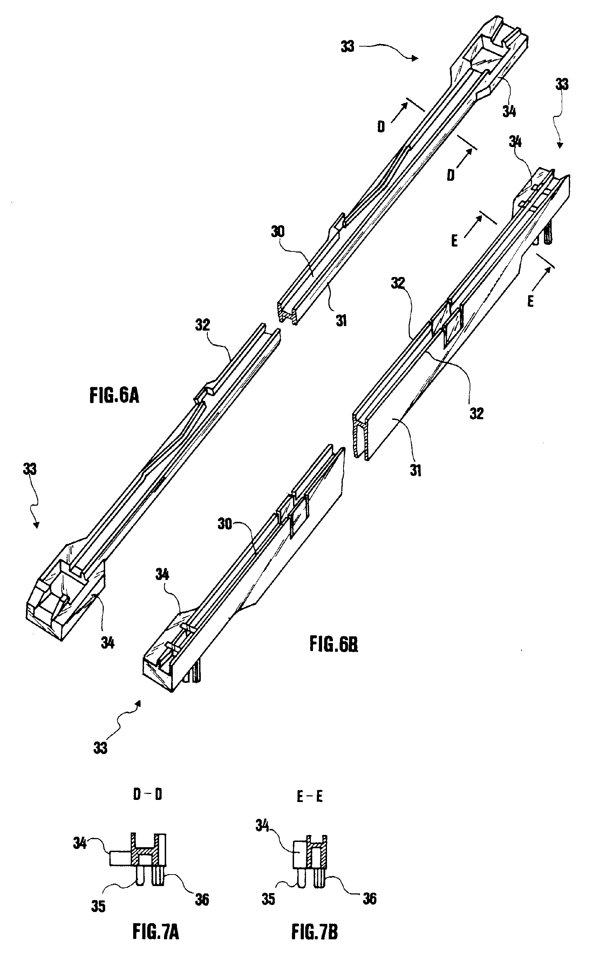

By connecting the plates 22 to the rails 1, the subrack 20 is structurally assembled. In order to allow the insertion of the electronic cards, indicated with S in figure 8, the adoption of an additional component of the subrack 20 becomes necessary: the removable insertion runways 30 (Figs. 6a, 6b, 7a, 7b).

Said movable runway 30 is preset onto a fluted rod 31, provided with longitudinal ribs 32 delimiting said runway 30.

The runways 30 are apt to receive the lower and upper edges of the electronic cards during the assembling thereof inside of the subrack 20. For this purpose, the runways 30 have an extension such as to allow the connection of opposed rails 1 located onto the access side 21 and on the opposite side of the subrack 20.

Moreover, the rod 31 has, at the ends thereof, coupling means 33, comprising an expanded section 34 from which a pair of pins overhang: particularly, a first pin 35 and a second ratchet pin 36, apt to fix in the receiving seat thereof.

Then the rods 31 are located with the pins 35, 36 inserted in the respective third fastening opening 13. The distance between centres of the pins 35, 36 substantially equals the pitch between said third openings 13.

Two alternative models of the rod 31, suitable for assembling cards according to different standards are shown in Figs. 6a, 6b, 7a, 7b.

Therefore, in order to carry out the insertion of the card S, once the subrack 20 is mounted and assembled in its own cabinet, a movable runway 30 is applied at the bottom thereof, plus an optional and additional movable runway at the top thereof, thus creating a single or double invitation to the insertion.

Once the card S is inserted up to the pin-plug coupling (not shown) usually located at the rear of the subrack 20, the ends S2 of the strap S1 are fastened at the preselected fastening seats 10, 12, made in the respective front rails 1.

It is apparent that the above disclosed subrack 20 merely consists of two components: the rails 1 and the plates 22; plus a pair of attachments: the fastening strip 11 and the movable runways 30, plus assembling devices with conventional fastening means like rivets, bolts and screws, ratchet pins, etc..

Those components are: the rails 1 to parallelepipedally shape the subrack 20, likewise plates 22, plus assembling means that, in the present embodiment, are the rivets 24.

The rails and the plates can be assembled in any position. Hence, the subrack is remarkably easy to assemble and it can be provided to the users as an assembly kit.

Furthermore, the above described rail 1 is obtained from a single sheet metal suitably trimmed and subjected to cold forging, punching, cold bending and galvanising steps in order to attain the finished product, i.e. the rail 1.

The hereto disclosed rails and subrack relate to a subrack type lacking the shielding plane separating the individual subrack from other subracks stacked inside a cabinet for electronic components.

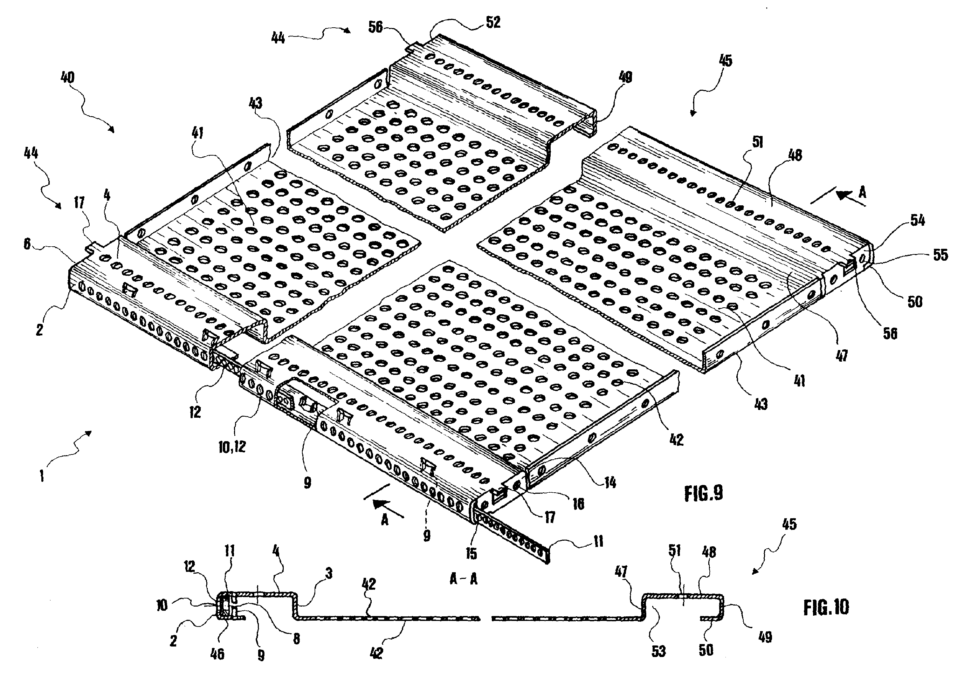

With reference to figures 9 to 11, a second embodiment of a rail according to the present invention will hereinafter be disclosed, incorporated in a rail-shielding plane set, indicated with 40 in the Figures, in which components equivalent to the ones hereto described shall be referred to using the same number references.

The assembly 40, in galvanised steel sheet, has a rectangular shielding plane 41, of a foraminated type and obtained from a single metallic conductor material sheet, i.e. a suitably forged sheet metal.

The shielding plane 41, thus comprising a plurality of ventilation openings 42, has a pair of side edges 43 opposed therebetween, and a pair of shaped edges 44 in order to incorporate a front rail according to the present invention, hereinafter indicated with 1, and a rear rail 45.

The rail 1 has a flattened, elongated parallelepipedal and boxed shape, developing along the front edge of the shielding plane 41. It has a front wall 2 and a rear wall 3, connected therebetween by a base wall 4; first ends 6 at the corners of the assembly 40; and a first inner channel ideally delimited by said walls 2, 3, 4.

The rear wall 3 is directly connected to the shielding plane by bending. Moreover, the front wall 2 is frontally bent at 90° with a first lower strip 46 towards the shielding plane and coplanarly to the latter, constituting a single front runway.

At the front runway, the rail 1 comprises a fastening guide 8, that therefore is obtained in the inner channel.7, The fastening guide is adjacent to the front wall 2, being delimited precisely by the face thereof internal to the rail 1.

At the base wall 4, the rail 1 comprises a plurality of tongues 9, belonging to the plate and advantageously obtained by punching, in such a manner that those be bent internally to the inner channel 7 for delimiting said fastening guide 8.

The rail 1 comprises a plurality of first fastening openings 10, particularly circular holes, obtained, e.g., by cold forging.

Said first openings 10 are sequentially located along said front wall 2, evenly spaced with a minimal pitch.

The rail 1 further comprises an attachment, physically separated therefrom functionally connected thereto, consisting of a fastening strip 11, i.e., a stiff metal strip apt to be inserted inside said fastening guide 8 and to be locked therein, having transversal dimensions allowing a minimal sliding clearance inside the guide 8.

Thus, the fastening strip 11 is located adjacently to the front wall 2, particularly to the inner face thereof. It has a plurality of second fastening openings 12 that are located in a position to correspond to the respective first fastening openings 10 when the fastening strip 11 is locked in the fastening guide 8. For this purpose, the second openings 12 are sequentially located along the fastening strip 11, evenly spaced with the same minimal pitch of the first openings 10.

Thus, together the first fastening openings 10 and the respective second fastening openings 12 are apt to embody a fastening seat 10, 12.

Also the second fastening openings 12 are circular holes, that, in the present embodiment, have a slightly shorter diameter than that of the first fastening openings 10. Moreover, the second openings are counterthreaded onto the inner surface thereof for fastening screw means inside of the fastening seat 10, 12.

The rail 1, at the first base wall 4 thereof, e.g. the upperly positioned one, has a plurality of third fastening openings 13, sequentially located on a row developing lengthwise the rail.

Alike what mentioned above, also the third openings 13 are obtained by sheet cold forging, prior to the bending and galvanising steps thereof. They are evenly spaced with a minimal pitch and conjugate to respective fourth openings 51 of the rear rail 45 (Figure 9), realising a even spacing perpendicularly to the development of the rails 1, 45.

The object of the third and of the fourth openings 13, 51 is that of housing movable runways as disclosed with reference to Figures 6a, 6b, 7a, 7b.

The front rail 1 comprises, at the first ends 6 thereof, a first cap 14 belonging to the sheet metal, connected to the base wall 4 and with a 90° bending for closing the first inner channel 7.

At the insertion guide 8, the first cap 14 is truncated and together with the edges of the base wall 4, of the first lower strip 46 and with the edge of the front wall 2, it embodies an insertion slot 15 of the fastening strip 11.

Overall, the front wall 2, the base wall 4, the first lower strip 46, the tongues 9 and the first caps 14 embody the bent portions of the plate defining the fastening guide 8.

First side holes 16 are obtained onto the first caps 14. The rail 1 has a first dowel 17 centrally notched in the respective first cap 14 and not bent therewith, as it belongs to the first base wall 4.

The construction of the rear rail 45 is symmetrical to the front rail 1, lengthwise to the assembly 40. Hence, it has an inner wall 47, connected to the shielding plane 41; an upper wall 48; an outer wall 49; a second lower strip 50; said fourth fastening openings 51 obtained onto the upper wall 48, second ends 52 and second inner channel 53.

At the second ends 52, the rear rail 45 comprises a second cap 54 belonging to the sheet metal, connected to the upper wall 48 and with a 90° bending for closing the second inner channel 53. The second cap 54 completely obstructs the respective end 52.

Internally threaded second side holes 55 are obtained onto the second caps 54. The rear rail 45 has a second dowel 56 centrally notched into the respective second cap 54, not bent therewith as it belongs to the upper wall 48.

The shielding plane 41 comprises, at the side edges 42 thereof, a respective side strip 57 coplanar to the first and second cap 14, 54 and making a nearly continuous individual strip therewith. Said side strip belongs to the same plate and it is obtained from the shielding plane 41 with a mere 90° bending.

Third side holes 58 are formed on each side strip 57, aligned to the preceding first and second side holes 16, 55.

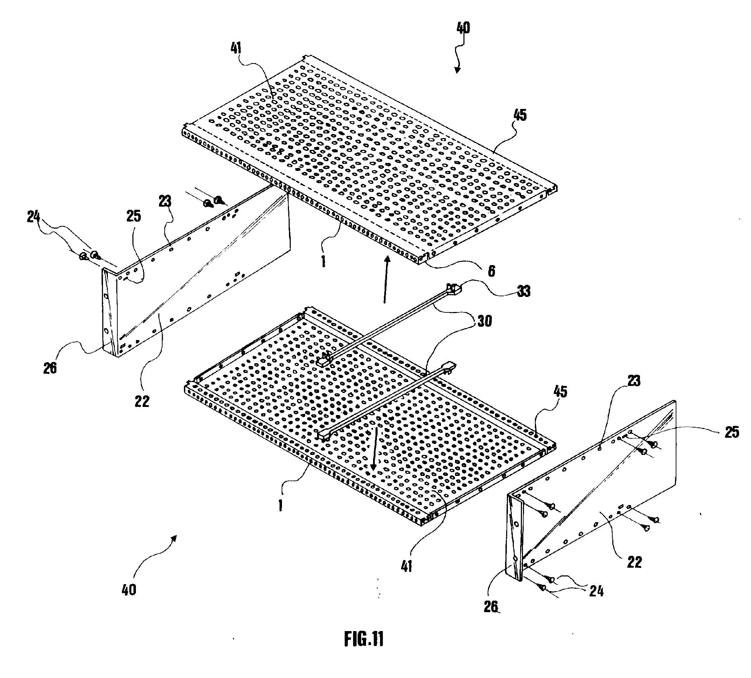

Likewise the former assembly (Figure 11), in order to mount a subrack 20 incorporating said rail-shielding plane 40 assembly the following steps are taken.

The subrack 20 is shaped like the above described one, having a opened front access side 21. It comprises two of said assembly 40 with the rails 1, 45 at the longitudinal corners of the subrack 20.

The rails 1, 45 and the shielding planes 41 are fastened to rectangular plates 22, located at the end faces of the subrack 20. The plates 22 comprise pairs of counterholes 23, located at the first, second and third side holes 16, 55, 58 and apt to embody with the latter a housing seat of an assembling device, the rivets 24. Further, there is a slot 25 apt to be engaged by said first and second dowel 17, 56.

At the frontally positioned edge of the plate 22, the latter has a further drilled fastening strip 26, for mounting the subrack 20 inside of a cabinet for electronic components.

In this case as well, the plates 22 are symmetrical with respect to a median axis concordant to the direction of insertion of the electronic cards.

Prior to fastening the plates 22 to the rails 1, 45, the respective fastening strips 11 have to be fastened, resulting correctly locked in when the assembly of the plates 22 is over, taking into account that the front rails 1 and the fastening strips 11 are of equal length, thus embodying the fastening seats 10, 12.

By connecting the plates 22 to the rails 1, the subrack 20 is structurally assembled. To allow the insertion of the electronic cards, indicated with S in figure 8, the use of said additional components of the subrack 20, the movable insertion runways 30 (figure 6a, 6b, 7a, 7b), is required.

Therefore, in order to carry out the insertion of the card S once the subrack 20 is mounted and assembled inside its own cabinet, a lower movable runway 30, plus an optional and additional upper movable runway, are applied, realising a single or a double invitation to the insertion.

Once the card S is inserted up to the pin-plug coupling (not shown) usually located at the rear of the subrack 20, the ends S2 of the strap S1 are fastened at the desired fastening seats 10, 12, obtained in the respective front rails 1.

Apparently, also the above described subrack 20 merely consists of two components: the assemblies 40 and the plates 22, plus a pair of attachments: the fastening strip 11 and the movable runways 30, plus assembling means with conventional fastening members like rivets, screws and bolts, etc.; hence the subrack is remarkably easy to assemble, and it can be provided to the users as an assembly kit.

Moreover, said above disclosed assembly 40 with the front rail 1 according to the invention is obtained from an individual sheet metal suitably trimmed and subjected to forging, punching, cold bending and galvanising steps to attain, as a finished product, the rail 1.

Moreover, the integral connection between the shielding plane and the rails ensures the required electrical continuity, with no additional component possibly complicating the assembly of the subrack.

To the above-described bent section rail of subrack for electronic components and subrack for electronic components comprising said bent section rails a person skilled in the art, in order to satisfy further and contingent needs, may effect several further modifications and variants, all however comprised within the protective scope of the present invention, as defined by the annexed claims.

## Claims

1. A bent section rail (1) of subrack (20) for electronic components, of a type incorporating fastening systems for the installation of electronic cards (S), located inside of the subrack (20) for electronic components, characterised in that it comprises:
* a plate bent in an elongated parallelepipedal boxed shape, defining a inner channel (7), so that the rail (1) has a front wall (2) connected to a base wall (3), developed lengthwise with respect to the rail (1);
* a fastening guide (8), formed in the inner channel (7) along said front wall (2) and defined by bent portions (2, 4, 5, 9, 14) of said plate;
* a plurality of first fastening openings (10), formed in said front wall (2); and
* a fastening strip (11), apt to be inserted and locked in said fastening guide (8) adjacently to the front wall (2), having a plurality of second fastening openings (12) located in a position to correspond to the respective first fastening openings (10) so as to embody a fastening seat (10, 12) therewith.

2. The rail (1) according to claim 1, wherein said elongated, parallelepipedal and boxed shape is flattened, said front wall (2) corresponding to one of the longitudinal faces with a reduced thickness.

3. The rail (1) according to any one of the claims 1 or 2, wherein said plate is a metal sheet.

4. The rail (1) according to claim 3, wherein said metal sheet is made of galvanised steel.

5. The rail (1) according to any one of the preceding claims, wherein, at the base wall (4), the rail (1) comprises a plurality of tongues (9) bent inside the inner channel (7) for delimiting said fastening guide (8).

6. The rail (1) according to any one of the preceding claims, wherein the second fastening openings (12) have a counterthread onto the inner surface thereof, for fastening screw means inside the fastening seat (10, 12).

7. The rail (1) according to any one of the preceding claims, wherein at the upper base wall (4) the rail (1) has a plurality of third fastening openings (13), evenly spaced with a minimal pitch, sequentially located along a row developing lengthwise with respect to the rail (1), for assembling movable runways (30).

8. The rail (1) according to any one of the preceding claims, comprising at the ends (6) thereof a cap (14) belonging to the plate, connected to the base wall (4) and bent for closing the inner channel (7), said cap (14) being truncated at the insertion guide (8), to form a insertion slot (15) of the fastening strip (11).

9. The rail (1) according to claim 1, comprising a front wall (2) and a rear wall (3), connected therebetween by a base wall (4), the rear wall (3) being directly connected to a shielding plane (41) by bending, said rail (1) being positioned at a front edge (44) of the shielding plane (41).

10. The rail (1) according to claim 9, comprising at the rear edge (44) thereof a further symmetrical rear rail (45).

11. A subrack (20) for supporting electronic cards (S) comprising at least one pair of rails (1) according to any one of the preceding claims, at the front access side (21) thereof.

12. A assembly kit of a subrack (20) for supporting electronic cards (S) comprising rails (1) according to any one of the claims 1 to 11; a pair of equal side plates (22); and assembling means (24).
